# EUROPEAN PATENT APPLICATION

(11) **EP 1 923 484 A1**
(43) Date of publication of application: **21.05.2008**
(21) Application number: 05781581.3
(22) Date of filing: 05.09.2005
(51) Int. Cl.: C23C 16/27, C23C 16/505

(54) **DLC FILM-FORMING APPARATUS**

(71) Applicant: Fukuwauchi Technologies Inc., Ota-ku Tokyo 146-0092 (JP)
(72) Inventor: UCHI, Tomio, 1460084 (JP); CAI, Shaobu, Tokyo;1870001 (JP)
(74) Representative: Stachow, Ernst-Walther
(86) International application number: PCT/JP2005/016209
(87) International publication number: WO 2006/073012

(57) **Abstract**

In a conveyance line for work that is produced by forming semi-finished containers on a container-forming-plastic sheet that is continuous in a belt shape, DLC films can be formed in the line on the surfaces of the intermittently arriving semi-finished containers without use of a special loading/unloading mechanism. An upper casing (11A) placed above a conveyance line for work (W) and a lower casing (11B) below the conveyance line are joined to form a vacuum chamber (11) that receives intermittently arriving semi-finished containers (3...) by a predetermined number of containers for each arrival and applies DLC coating on the surfaces of the containers. A seal material (32) is attached to the portion of the joining, and the seal material is capable of maintaining the inside of the chamber (11) at vacuum of 0.5-5000 Pa. Also, when the semi-finished containers (3...) are loaded into and unloaded from the vacuum chamber (11), the casings (11A, 11B) are relatively moved in the direction where the casings are separated from each other, enabling the loading and unloading of the containers.

## Description

### Technical Field

The present invention concerns a DLC film-forming apparatus for forming a DLC film to the surface of semi-finished container products in a conveyance line for intermittently conveying works prepared by forming semi-finished container products each at a predetermined interval to a container-forming plastic sheet which is continuous in a belt-like shape.

### [Background Art]

In a case of producing plastic containers such as soybean paste containers, it is a general procedure of sandwiching a plastic sheet of a predetermined width between dies having molding-cavities formed in a matrix while unwinding off the sheet from a roller and intermittently conveying the same, vacuum forming or pressure forming semi-finished container products, and then cutting to separate the semi-finished products one by one.

In such plastic containers for use in foods, a high gas barrier property is required in order not to permeate gases such as oxygen or steams in order to prevent oxidation or moisture absorption for contents.
Then, such a demand has been coped with by forming a container with a multi-layered plastic sheet formed by laminating a gas barrier material such as Eval (trade name of products from Kuraray: ethylene-vinyl alcohol copolymer resin) or Barex (trade name of product from Mitsui Chemical Co.: Acrylonitrile type thermoplastic resin) as transparent plastics.
[Patent Document 1: JP-A No. 5-104572]

However, in a case of forming a food container with a multi-layered plastic sheet, there has bee a problem that the material cost is expensive and the production cost reaches as much as 4 to 5 times the usual case.
Further, while a gas barrier film of 20 µm thickness is laminated and formed by one layer or more in a plastic sheet of 1 mm thickness, it include 2% impurities even in a single layer based on simple calculation when put to a recycling treatment and the impurity concentration further increases as the number of layer increases as two layers or three layers to result in a problem that the recycle adaptability is poor.

On the other hand, plastic bottles formed with a DLC film (diamond-like carbon film) as a gas barrier material has attracted attention in recent years, and technique of forming the DLC film to a plastic plastic sheet has also be proposed.
[Patent Document 2] JP-A No. 2003-147526

The DLC film is a film of amorphous carbon comprising mainly inter-carbon SP³ bond and, since the film has excellent physical and chemical characteristics such as high gas barrier property, low friction property, high hardness, highly electrical insulation property, high refractive index, high heat dissipation property, and high corrosion resistance, and has a sufficient gas barrier property at a film thickness of from 0.03 to 0.1 µm, the impurity concentration during the recycle treatment is extremely low and, accordingly, it is excellent in the recycle adaptability.

However, when it is intended to form the plastic container as described above by using the plastic sheet formed of the DLC film, the thickness of the wall in the direction of the height of the container decreases to 1/3 or less of the sheet thickness due to the stretching of the plastic sheet upon vacuum forming/pressure forming and, accordingly, the bas barrier property of the DLC film formed on the sheet surface is also lowered.

While it may be considered that a DLC film is not formed on the plastic sheet but the DLC film is formed after cutting into individual containers, when such a line is intended to be automated, since this requires a loading device for loading from the container conveyance line to a vacuum chamber for applying DLC coating, and an unloading device for unloading the container completed with film formation from the vacuum chamber, this involves a problems of requiring an enormous installation cost and expensive labor cost for managers.
Further, in the existent plastic container forming line, vacuum forming is conducted at about 15 sec interval, semi-finished container products by the number of several tens are formed by the vacuum forming for once and, in a case of cutting them into an individual container and applying DLC coating on every containers, it resulted in a problem of remarkably lowering the production efficiency for the containers.

### [Disclosure of the Invention]

### [Subject to be Solved by the Invention]

In view of the above, it is a technical subject of the present invention to enable assembling into a conveyance line of works prepared by forming semi-finished container products each at a predetermined interval to a container-forming plastic sheet which is continuous in a belt-like shape, and enable formation of a DLC film, in an in line system, to the surface of semi-finished container products arriving intermittently, without using any special loading or unloading mechanism at all.

### [Means for Solution of the Subject]

For solving the subject, the present invention provides a DLC film-forming apparatus of forming a DLC film on the surface of semi-finished container products in a conveyance line in which works prepared by forming semi-finished container products are conveyed each at a predetermined interval to a container-forming plastic sheet which is continuous in a belt-like shape, wherein a vacuum chamber for containing the semi-finished container products arriving intermittently each by predetermined unit numbers and applying DLC coating to the surface thereof is provided in the conveyance line, the chamber is formed by joining a first casing provided with a high frequency electrode for DLC coating and a second casing provided with a ground electrode while sandwiching the conveyance line therebetween, a seal member capable of keeping the inside of the chamber to a vacuum degree of from 0.5 to 5,000 Pa is disposed to the joined portion, in which both of the casings are constituted such that they move relatively in the directions receding from each other upon loading and unloading of the semi-finished container products to and from the chamber thereby enabling loading and unloading thereof.

### [Effect of the Invention]

In the DLC film-forming apparatus according to the invention, since the vacuum chamber for containing the semi-finished container products each by predetermined unit numbers of arriving intermittently to the conveyance line and applying DLC coating to the surface thereof is formed by joining the first and the second casings to each other with the conveyance line being put therebetween, they are moved relatively in the direction receding from each other when the semi-finished container products are loaded or unloaded along with conveyance of works.
Then, when each of the casings is joined and the semi-finished container products are contained by the predetermined unit numbers, the inside of the chamber is depressurized, a raw material gas is introduced, and the high frequency voltage is applied between the electrodes, the DLC film is formed to the inner surface of the work.
Then, when the casings are detached from each other at the instance the film formation has been completed and the works are conveyed, the semi-finished container products formed with the DLC film are unloaded and, at the same time, the not yet treated succeeding semi-finished container products are loaded and the DLC film forming treatment is applied by repeating them.

As described above, since the DLC film is formed to the semi-finished container products by the unit numbers arriving intermittently by opening and closing the casing, when the unit number thereof is made equal with the number formed by the vacuum forming/pressure forming at once, DLC film can be formed, in an in-line system, at the identical production efficiency in synchronization with vacuum-forming/pressure forming.
Further, the semi-finished container products can be loaded and unloaded into and out of the chamber with no provision of any special loading or unloading device and the DLC forming treatment can be applied efficiently.
Further, since the seal member capable of keeping the inside of the chamber to a vacuum degree of from 0.5 to 5,000 Pa is provided to the joined portion for each casing, no air leakage occurs in the chamber even when pressure is decreased for conducting DLC coating.

### [Best Mode for Practicing the Invention]

In this embodiment, for attaining the object of enabling assembling into a conveyance line for intermittently covering works prepared by forming semi-finished container products each at a predetermined interval to a container-forming plastic sheet which is continuous in a belt-like shape, and enabling of formation of a DLC film, in an in-line system, to the surface of semi-finished container product without using any special loading or unloading mechanism at all, a vacuum chamber is provided for containing the semi-finished container products arriving intermittently to the conveyance line each by predetermined unit numbers and applying DLC coating to the surface thereof, the chamber is formed by joining a first casing provided with a high frequency electrode for DLC coating and a second casing provided with a ground electrode to each other while putting the conveyance line therebetween, the seal member capable of keeping the inside of the chamber to a vacuum degree of from 0.5 to 5,000 Pa is disposed to the joined portion, and both of the casings are moved relatively in the directions receding from each other upon loading or unloading the semi-finished container products thereby enabling loading or unloading thereof.

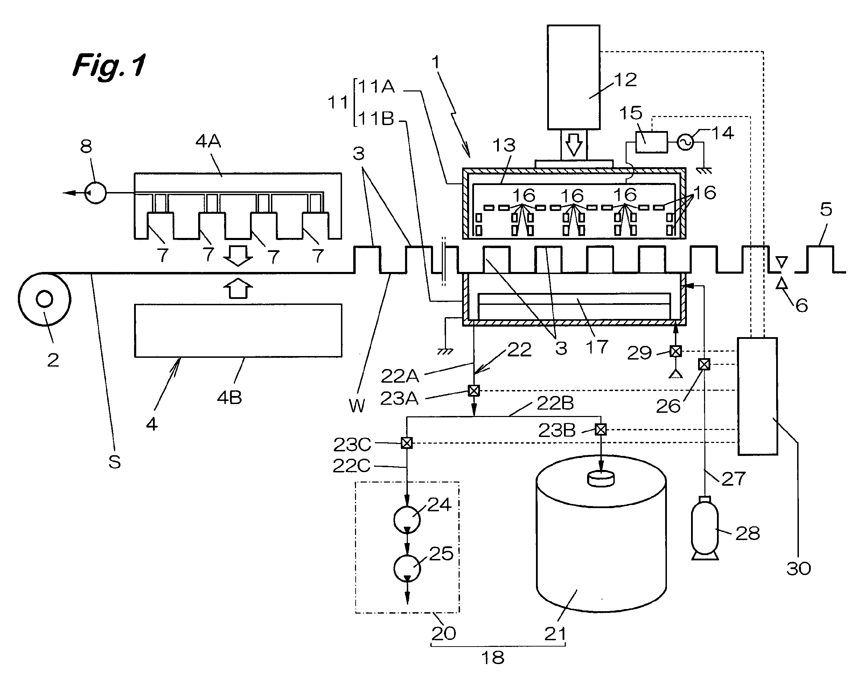

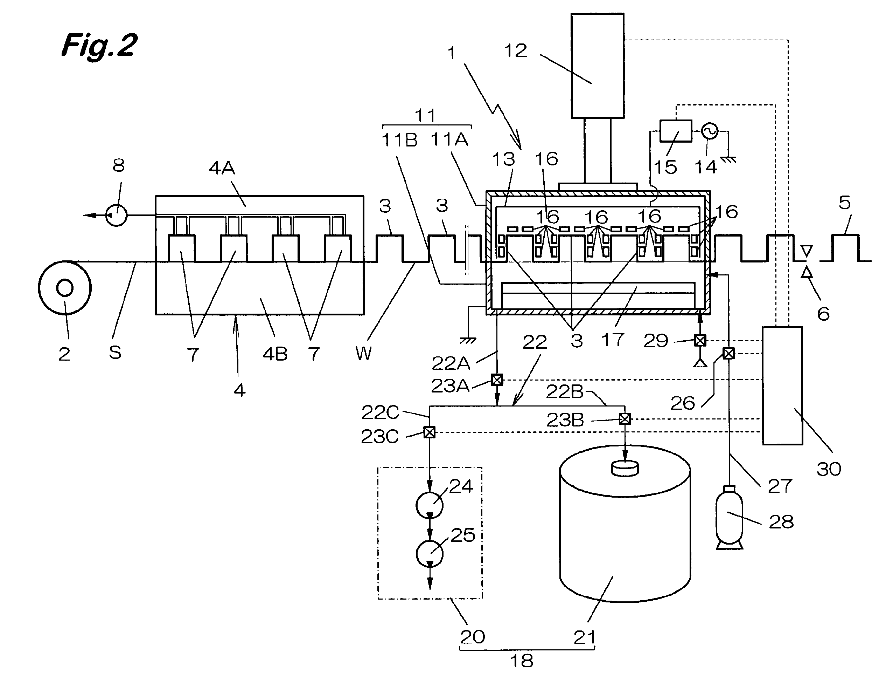

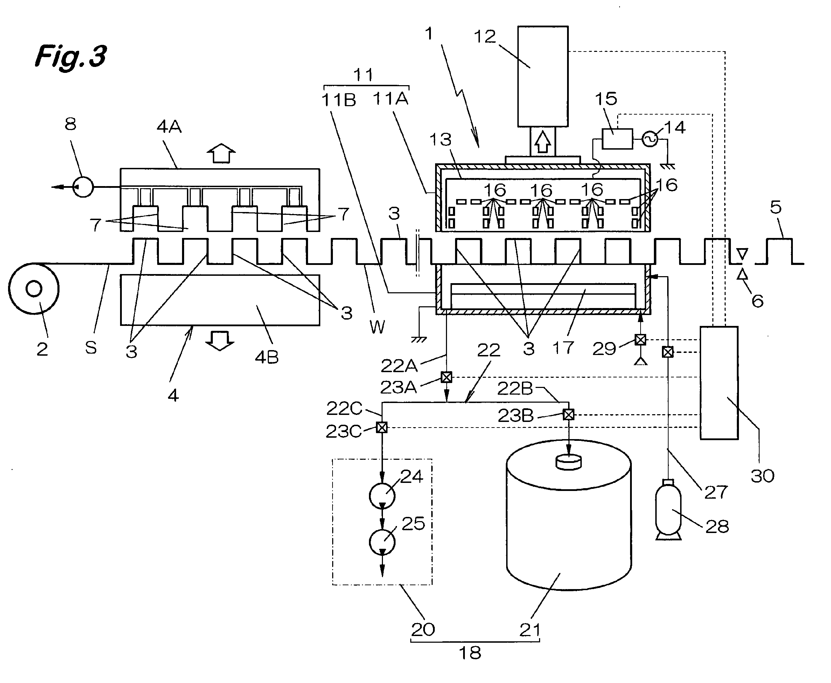

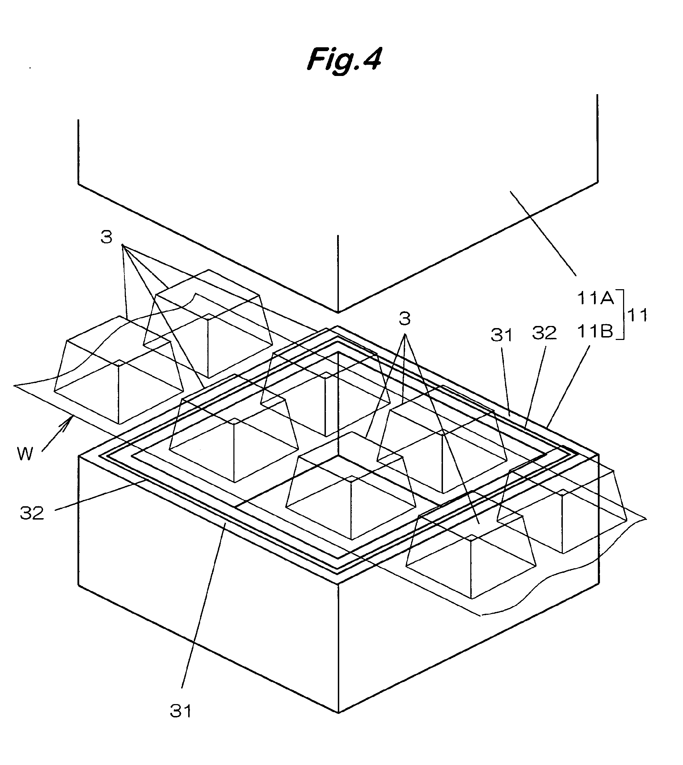

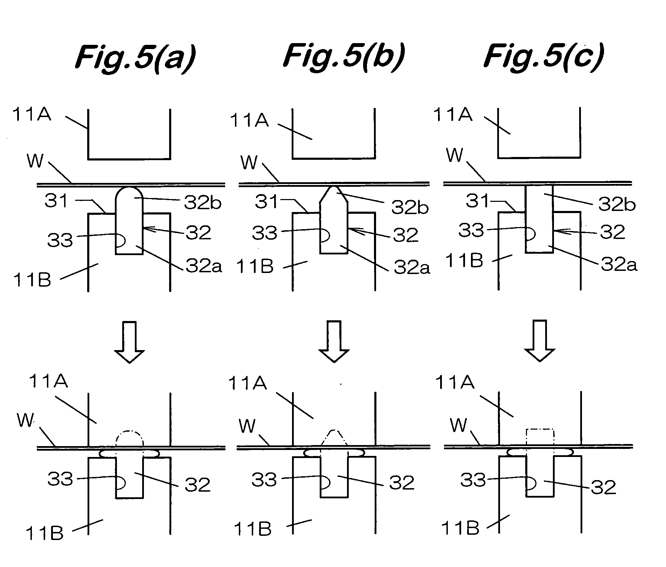

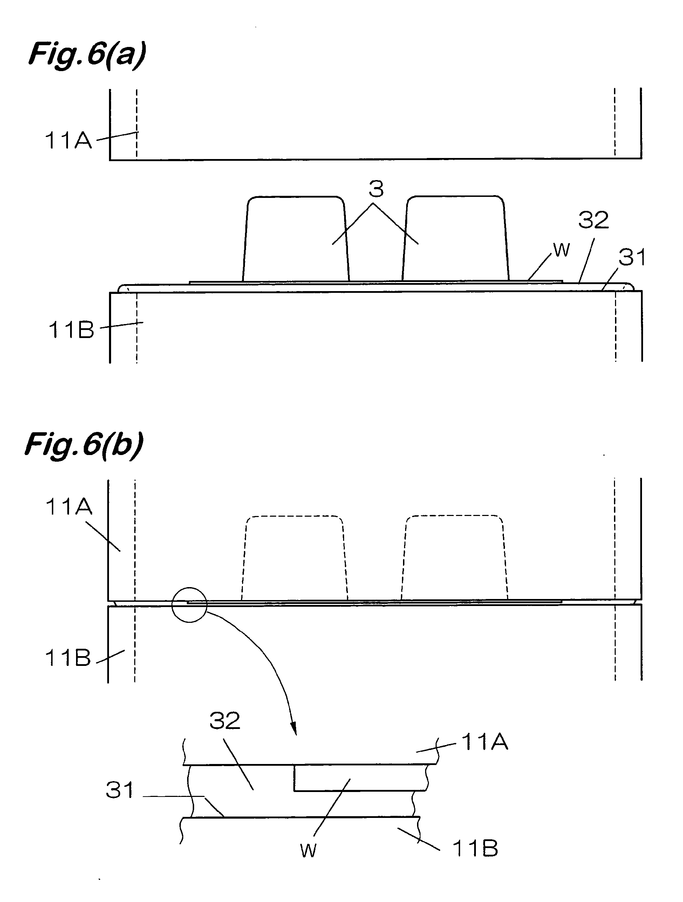

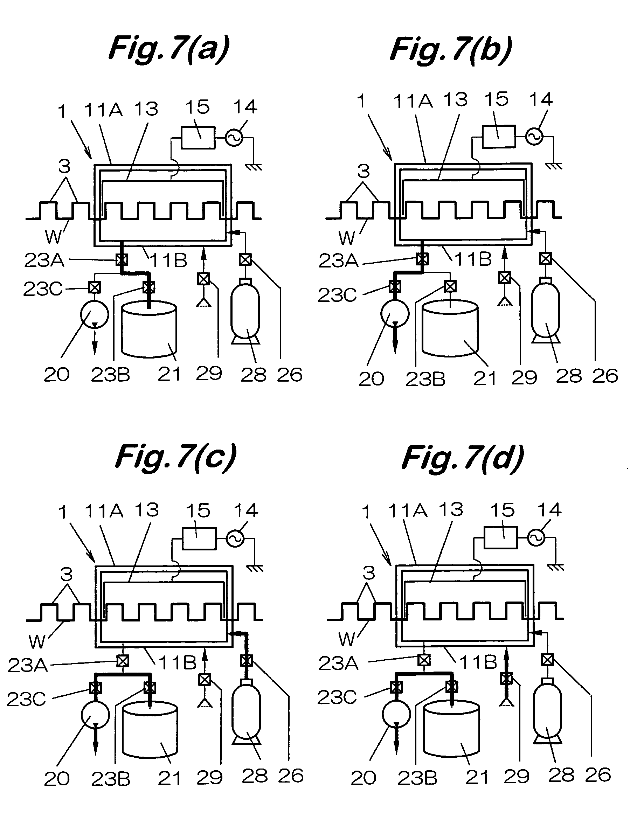

Fig. 1 is an explanatory view showing an example of a DLC film-forming apparatus according to the invention, Fig. 2 and Fig. 3 are explanatory views showing the operation thereof, Fig. 4 is an explanatory view showing the state of attaching a seal member, Fig. 5 is an explanatory enlarged view schematically showing a deformed state of the seal member, Fig. 6 is a front elevational view showing the deformed state of the seal member, and Fig. 7 is an explanatory view showing the on-off sequence of each of valves.

### [Example 1]

Referring to a DLC film-forming apparatus 1 shown in Figs 1 to 3, in a conveyance line for intermittently conveying works W produced by forming semi-finished container products 3 each at predetermined interval to a container-forming plastic sheet S which is continuous in a belt-like shape, and it is installed being assembled in a production line for cup-shaped plastic food containers such as soybean paste containers.
In the production line, a vacuum forming machine 4 for forming semi-finished container products 3 --- each at a predetermined interval to a container-forming plastic sheet S which is continuous in a belt-like shape wound off from a raw material roll 2, a DLC film-forming apparatus 1 for forming a DLC film on the inner surface of the semi-finished container product 3 to works W prepared by forming the semi-finished container products 3 ---, and a cutter 6 for cutting and separating the semi-finished container products 3 --- formed with the DLC film from the plastic sheet S into individual containers 5 are located sequentially, in which vacuum forming treatment, DLC film-forming treatment, and cutting treatment are conducted simultaneously which the plastic sheet S and the works W in continuous therewith are being stopped while intermittently conveying the works W.

The vacuum forming machine 4 has a pair of upper and lower vacuum forming dies 4A and 4B for sandwiching the plastic sheet S preheated by a heater (not illustrated), in which the upper die 4A is formed with cavities 7 --- each in a container shape are formed, for example, by the number of 35 in a 5 × 7 matrix and connected with a vacuum pump 8 for depressurizing the inside of the cavities 7 --- and vacuum forming the semi-finished container products 3 ---.
Thus, works W prepared by forming the semi-finished container products 3 --- with the inner surface being downwarded each at a predetermined interval being protruded upward of the plastic sheet S are unloaded out of the vacuum forming machine 3.
Further, in this embodiment, a tact time from clamping the upper and the lower dies 4A and 4B to sandwich the plastic sheet S till the formation of the semi-finished container products 3 --- is selected, for example, to about 15 sec. Accordingly, the plastic sheet S is conveyed intermittently at about 15 sec interval and the semi-finished container products 3 --- are formed and delivered each by the unit numbers of 35.

In the DLC film-forming apparatus 1, a vacuum chamber 11 is provided for containing the semi-finished products 3-- arriving intermittently to the conveyance line for the works W each by predetermined unit numbers (by the number of 35 in this embodiment) and applying a DLC coating to the inner surface (surface) thereof. The chamber 11 is formed by joining an upper casing (first casing) 11A situated above and a lower casing (second casing) 11B situated below the conveyance line for the works W while sandwiching the same, and a seal member 32 capable of keeping the inside of the chamber 11 to a vacuum degree of from 0.5 to 5000 Pa is provided to the joined portion.
Further, both of the casings 11A and 11B are adapted such that they move relatively in the directions receding from each other upon loading or unloading of the semi-finished container products 3 thereby enabling loading and unloading thereof and, in this embodiment, the upper casing 11A is situated above is adapted to move vertically in a direction substantially perpendicular to the conveying direction of the works W by an oil pressure cylinder 12.

In the upper casing 11A, a box-type high frequency electrode 13 is disposed being opposed to the outer surface of the semi-finished container products 3 --- contained in the chamber 11, a high frequency power source 13 is connected by way of a matching device 15 to the high frequency electrode 13, and permanent magnets 16 are arranged in the high frequency electrode 13 such that they situate in the vicinity of individual semi-finished container products 3---.

Further, in the lower casing 11B, a plate-like ground electrode 17 opposed to the inner surface of the semi-finished container products 3 --- contained in the chamber 11 is disposed, and a depressurizing device 18 capable of depressurizing the inside of the chamber 11 to 0.5 to 5000 Pa when casings 11A and 11B are joined is connected, and the attainable vacuum degree is set to 0.5 to 15 Pa in this embodiment.
It is defined as from 0.5 to 5000 Pa, since a special and expensive pump has to be used for a vacuum pump unit 20 to be described later in order to lower the degree to less than 0.5 Pa, whereas formation of the DLC film is difficult at 5000 Pa or more. Further, from 0.5 to 15Pa is preferred because this can be attained in a short time even by a relatively inexpensive vacuum pump unit 20, and the DLC film can also be formed to a predetermined thickness in a short time.

The depressurizing device 18 has a vacuum pump unit 20 and a pre-pressure tank 21 previously maintained at a depressurized state, each of which is connected by way of a three-way pipeline 22 to the casing 11B and on-off valves 23A to 23C are intervened in the respective branch tubes 22A to 22C.
The vacuum pump unit 20 has a mechanical booster 24 and an oil rotation vacuum pump connected to the succeeding stage thereof and is designed so as to attain a vacuum degree of about several Pa.

The pre-pressure tank 21 is used for instantaneously depressurizing the chamber 11 at an atmospheric pressure (100,000 Pa) to 5,000 Pa or less at which a vacuum pump unit 20 operates at high efficiency, and it is set to a volume ratio to the chamber 11 of 20 times or more and 200 times or less in accordance with the pressure ratio. In this embodiment, it is selected to 2.5 m³ which is 25 times as large as 0.1 m³ volume of the chamber 11.
In a case where the volume ratio is less than 20 times, the chamber 11 in the atmospheric pressure can not be depressurized to 5,000 Pa or less, whereas in a case where it exceeds 200 times, the capacity is excessively large, which not only takes much installation cost but also requires a large capacity pump when depressurizing the prepressure tank 21 which is not preferred also with a view point of the operation efficiency.

Further, a material gas supply tank 28 is connected by way of a raw material introduction pump 27 with an on-off valve 26 intervened to the lower casing 11B, and a leak valve 29 is disposed for instantaneously returning the inside of the chamber 11 to an atmospheric pressure after the completion of the film-forming treatment.

Then, each of the valves 23A to 23C, 26, and 29, the oil pressure cylinder 12 for elevating the upper casing 11A, and the matching device 15 for applying the high frequency voltage to the high frequency electrode 13 are controlled for the respective operations thereof by a control device 30 to which timing signals of a conveying mechanism (not illustrated) of the works W are inputted.

Further, at the open end face of the lower casing 11B that joins the upper casing 11A (joined portion) 31, a square groove 33 for fitting a seal member 32 capable of keeping the inside of the chamber 11 to a vacuum degree of from 0.5 to 5,000 Pa is formed over the entire circumference as shown in Fig. 5.
The seal member 32 has a cross section at the bottom surface 32a formed into a square shape fitted with no clearance into the square groove 33, and has a cross section at the top end portion 32b protruding in a state fitted into the square groove 33 into a semi-circular, semi-elliptic, semi-angular, or square shape.

As shown in Fig. 6, when the casings 11A and 11B are closed and the inside of the vacuum chamber 11 is depressurized, the seal member 32 is crushed and deformed by the upper casing 11A and is deformed so as not to form a gap even in a state of sandwiching the work W and can keep the inside of the chamber 11 air-tight.
According to the experiment made by the inventor, in a case of using the seal member 32 having the cross sectional shape described above shown in the drawing and having a rubber hardness of 10 or more and 30 or less (Durometer type A), 0.5 to 15 Pa can be attained.

An example of the constitution of the invention is as has been described above and the operation thereof is to be explained.
A plastic sheet S is wound off from the raw material roll 2, conveyed intermittently at an interval of about 15 sec, while works W prepared by forming semi-finished container products 3.. in the vacuum forming machine 4 are sent successively to the DLC film-forming apparatus 1.
In the DLC film-forming apparatus 1, the pre-pressure tank 21 is depressurized by the vacuum pump unit 20 to about several 100 Pa, and the upper casing 11A of the DLC film-forming apparatus is kept open till arrival of the semi-finished container product 3 --- from the vacuum forming machine 4 (refer to Fig. 1).

Then, base on a timing signal outputted upon stopping of the work W, the control device 30 extends the oil pressure cylinder 12 to join the casings 11A and 11B (refer to Fig. 2).
In this case, the seal member 32 attached to the casing 11B is crushed by the upper casing 11A and deformed with no clearance in a state of sandwiching the flat portion of the work W to keep the inside of the air chamber 11 air tight (Fig. 5 and Fig. 6).

In this case, as shown in Fig. 7(a), when the valves 23A and 23B are opened to communicate the chamber 11 with the pre-pressure tank 21, the inside of the chamber 11 is instantaneously depressurized by the pressure difference to 5,000 Pa or less.
Then, as shown in Fig. 7(b), when valve 23B is closed and the valves 23A and 23C are opened, to communicate the chamber 11 with the vacuum pump unit 20 that has been actuated, since the inside of the chamber 11 is depressurized to 0.5 to 15 Pa or less within several seconds, the valve 23A is closed at the instance.

Then, as shown in Fig. 7(c), when the valve 26 is opened to supply a raw material gas in a required amount from the raw material gas supply tank 28 and a predetermined high frequency voltage is applied from the high frequency power source 14, plasmas are generated between the electrodes 13 and 17.
Since the work W formed to the plastic sheet S is an insulator, it is charged negatively due to the self-bias induced to the surface thereof, high density ions concentrated in the plasmas are accelerated toward the plastic sheet S charged negatively, the ions at high speed and of high energy are guided along magnetic fields formed by the permanent magnets 16 and hit at a substantially right angle to the inner surface of the semi-finished container product 3 from the lower surface of the work W thereby forming a homogeneous DLC film over the entire inner surface of the semi-finished container products 3.
In the course described above, the valve 23B and the valve 23C are opened and air in the pre-pressure tank 21 is exhausted by the vacuum pump unit 20 to depressurize the pre-pressure tank 21 to about several 100 Pa.

When the leak valve 29 is opened as shown in Fig. 7(d) at the instance the film-forming treatment has been completed, since the inside of the chamber 11 resumes the atmospheric pressure instantaneously. Then, by repeating retracting the oil pressure cylinder 12 as shown I Fig. 2 to detach the upper casing 11A and open the chamber 11, delivering the semi-finished container products 3 --- after completion of the film-forming treatment for the DLC film under conveyance of the plastic sheet S to the cutting machine 6 and loading not-yet treated subsequent semi-finished container products 3 --- simultaneously, and repeating the foregoing procedures, the film-forming treatment of the DLC film for the semi-finished container products 3 --- can be applied in synchronization with the forming treatment by the vacuum forming machine 4.
Further, since the cutting machine 6 located in the stage substance to the DLC film-forming machine can also be operated in synchronization with them, in the production line for the containers 5, DLC film can be coated on every individual container 5 without lowering the production efficiency of the containers 5 by synchronizing all the forming treatment by the vacuum forming machine 4, the DLC film-forming treatment by the DLC film-forming apparatus 1 and the cutting treatment by the cutting machine 6 efficiently.

In the foregoing explanation, while description has been made to a case of forming the semi-finished container products 3 --- by vacuum forming to the plastic sheet S, this is identical also in a case of formation by pressure forming.

### [Industrial Applicability]

As has been described above, the invention is applicable to the application use of forming a DLC film, in an in-line system, to the inner surface of the semi-finished container products formed each at a predetermined interval to the plastic sheet while intermittently conveying a plastic sheet which is in continuous in the longitudinal direction.

### [Brief Description of the Drawings]

[Fig. 1] is an explanatory view showing an example of a DLC film-forming apparatus according to the invention.
[Fig. 2] is an explanatory view showing an explanation thereof.
[Fig. 3] is an explanatory view showing an explanation thereof.
[Fig. 4] is an explanatory view showing a state of attaching a seal member.
[Fig. 5] is an enlarged explanatory view schematically showing the deformed state of the seal member.
[Fig. 6] is a front elevational view showing the deformed state of the seal member.
[Fig. 7] is an explanatory view showing the on-off sequence of each of valves.

### [Description of References]

- 1: DLC film-forming apparatus
- S: plastic sheet
- W: work
- 3: semi-finished container product
- 4: vacuum forming machine
- 11: vacuum chamber
- 11A, 11B: casing
- 13: high frequency electrode
- 17: ground electrode
- 18: pressurizing device
- 20: vacuum pump unit
- 21: pre-pressurizing tank
- 30: control device
- 32: seal member

## Claims

1. A DLC film-forming apparatus of forming a DLC film on the surface of semi-finished container products in a conveyance line in which works prepared by forming semi-finished container products are conveyed each at a predetermined interval to a container-forming plastic sheet which is continuous in a belt-like shape, wherein
a vacuum chamber for containing the semi-finished container products arriving intermittently each by predetermined unit numbers and applying DLC coating to the surface thereof is provided in the conveyance line, the chamber is formed by joining a first casing provided with a high frequency electrode for DLC coating and a second casing provided with a ground electrode while sandwiching the conveyance line therebetween, a seal member capable of keeping the inside of the chamber to a vacuum degree of from 0.5 to 5,000 Pa is disposed to the joined portion, in which both of the casings are constituted such that they move relatively in the directions receding from each other upon loading and unloading of the semi-finished container products to and from the chamber thereby enabling loading and unloading thereof.

2. A DLC film-forming apparatus according to claim 1, wherein the high frequency electrode is formed into a box type surrounding the semi-finished container products in a case of forming the DLC film to the inner surface of the semi-finished container products.

3. A DLC film-forming apparatus according to claim 2, wherein permanent magnets are disposed so as to situate in the vicinity of the semi-finished container products contained in the vacuum chamber.

4. A DLC film-forming apparatus according to claim 1, wherein a depressurizing device for depressurizing the inside of the chamber to 0.5 to 5,000 Pa is connected, and a raw material gas introduction pipe is connected to one of the casings.

5. A DLC film-forming apparatus according to claim 4, wherein the depressurizing device has a vacuum pump unit connected by way of a pipeline of the chamber and a pre-pressure tank previously maintained at a depressurized state, and a control device is provided for on-off controlling of the value intervened to the pipeline so as to connect the chamber with the pre-pressure tank such that the inside of the chamber is preliminary depressurized by the pressure difference with respect to the pre-pressure tank when each of the casings is joined and the semi-finished container products are contained by the number of unit, and connect the chamber to the vacuum pump unit after the completion of the preliminary depressurization.

6. A DLC film-forming apparatus according to claim 1, wherein the seal member has a cross section at the bottom surface into a square shape that is fitted with no clearance into a square groove formed to one of the casings, and a cross section at the top end portion protruding from the square groove is formed into a semi-circular, semi-elliptic, angular, or square shape.

7. A DLC film-forming apparatus according to claim 1 or 6, wherein the rubber hardness of the seal member is selected so as to attain a vacuum degree of from 0.5 to 15 Pa when the inside of the vacuum chamber is depressurized.

8. A DLC film-forming apparatus according to claim 1 or 6, wherein the seal member is formed of a synthesis rubber with a rubber hardness of 30 (Durometer type A) or less.

9. A DLC film-forming apparatus according to claim 1, wherein a DLC film is formed to semi-finished container products by the number equal with that of the semi-finished container products formed simultaneously by the molding machine in synchronization with the conveyance timing of works unloaded from the a vacuum or pressure forming machine located in the stage preceding to the work conveyance channel.
